# EUROPÄISCHE PATENTSCHRIFT

(11) **EP 3 051 551 B1**
(45) Veröffentlichungstag und Bekanntmachung des Hinweises auf die Patenterteilung: **14.10.2020**
(21) Anmeldenummer: 15196247.9
(22) Anmeldetag: 25.11.2015
(51) Int. Cl.: H01H 27/00, F16P 3/08, H01R 13/514, H03K 17/945

(54) **MODULANORDNUNG MIT WENIGSTENS EINEM GRUNDMODUL**
MODULE ASSEMBLY WITH AT LEAST ONE BASE MODULE
ARRANGEMENT DE MODULE COMPORTANT AU MOINS UN MODULE DE BASE

(30) Priorität: 27.01.2015 DE 102015101133
(43) Veröffentlichungstag der Anmeldung: 03.08.2016
(73) Patentinhaber: EUCHNER GmbH + Co. KG, 70771 Leinfelden-Echterdingen (DE)
(72) Erfinder: Gehrke, Mike, 73269 Hochdorf (DE); Klaiber, Jörg, 71157 Hildrizhausen (DE)
(74) Vertreter: Ruckh, Rainer Gerhard

(56) Entgegenhaltungen:
- EP-A2- 2 650 993
- WO-A1-90/07814
- US-B1- 6 310 305
- Euchner Gmbh: "Betriebsanleitung Sicherheitssysteme", , 3. Januar 2015 (2015-01-03), XP055278921, Gefunden im Internet: URL:https://www.euchner.de/portals/0/siriu smedia/pim/data/210579.pdf [gefunden am 2016-06-08]

## Beschreibung

Die Erfindung betrifft eine Modulanordnung gemäß dem Oberbegriff des Anspruchs 1.

Modulanordnungen der in Rede stehenden Art umfassen ein oder mehrere Grundmodule, welche jeweils an zwei unterschiedlichen Seiten jeweils ein Anschlussmodul aufweisen sowie ein oder mehrere Funktionsmodule mit wenigstens einem Anschlussmodul. Die Grundmodule und die Funktionsmodule bilden generell Elektronikmodule, welche vorgegebene Funktionalitäten aufweisen. Diese Elektronikmodule können über die Anschlussmodule, die beispielsweise in Form von Steckern und Buchsen ausgebildet sind, zu einer Funktionseinheit verbunden werden.

Beispielsweise können derartige Modulanordnungen Sicherheitssysteme wie insbesondere Sicherheitszuhaltesysteme ausbilden. Ein derartiges System ist beispielsweise von dem Sicherheitssystem MGB der Firma Euchner gebildet. Dieses Sicherheitssystem gewährleistet ein sicheres Zuhalten von beweglich trennenden Schutzeinrichtungen, insbesondere Schutztüren und somit einen gesicherten Zugang zu eingezäunten sicherheitskritischen Gefahrenbereichen.

Dieses Sicherheitszuhaltesystem umfasst ein Zuhaltemodul, an welchem ein Griffmodul angeordnet ist. Diese Module dienen zum sicheren Zuhalten der Schutztür. Der Türdrücker des Griffmoduls kann durch Federkraft in zugehaltener Stellung gehalten werden und durch Magnetkraft entsperrt werden. Alternativ kann die Türdrücker durch Magnetkraft in zugehaltener Stellung gehalten werden und durch Federkraft entsperrt werden.

Das Sicherheitszuhaltesystem weist zudem als Funktionsmodule, die an das Zuhaltemodul angeschlossen werden können, ein Bedienmodul und ein Busmodul auf. Das Bedienmodul weist eine Bedieneinheit mit mehreren Tasten und Knöpfen auf. Das Busmodul dient zum Anschluss des Sicherheitszuhaltesystems an ein externes Bussystem.

Die einzelnen Module sind über Anschlussmodule wie Stecker und Buchsen verbunden, wobei von diesen Flachbandkabel ausgehen, die in den einzelnen Modulen verlaufen.

Ein wesentlicher Nachteil dieses Sicherheitszuhaltesystems besteht darin, dass bei einem in einem Modul auftretenden Defekt das gesamte Sicherheitszuhaltesystem zu Reparaturzwecken an den Hersteller zurückgeschickt werden muss.

Ein weiterer Nachteil des Sicherheitszuhaltesystems besteht darin, dass der konstruktive Aufwand für eine Anpassung an unterschiedliche Konfigurationen unerwünscht hoch ist. Unterschiedliche Konfigurationen treten insbesondere durch unterschiedliche Anordnungen der Schutztür relativ zum Sicherheitszuhaltesystem auf. Je nach Anordnung der Schutztür muss eine rechtsseitige oder linksseitige Anordnung eines Griffmoduls am Zuhaltemodul vorgesehen sein. Um diese Konfigurationen abdecken zu können, müssen unterschiedliche Varianten des Zuhaltemoduls vorgesehen werden, die verschiedene Konstruktionen für eine rechts- oder linksseitige Befestigung des Griffmoduls aufweisen.

Die US 6 310 305 B1 betrifft eine Sicherheitsschalteranordnung mit einem Schalterkörper und einem Verschlusskörper, der eine Öffnung zur Aufnahme eines Aktuators aufweist. Der Schalterkörper und der Verschlusskörper befinden sich an einer Wand, die eine Gebäudeöffnung begrenzt, welche mit einer Tür abschließbar ist. An der Tür befindet sich der Aktuator Durch Einführungen des Aktuators in die Öffnung des Verschlusskörpers kann die Tür im geschlossenen Zustand verriegelt werden.

Die EP 2 650 993 A2 betrifft ein Gehäuse, welches eine Steuereinrichtung zur Ausführung einer elektronischen Funktion beinhaltet, sowie Basismodul, das zur Befestigung des Gehäuses für eine vorbestimmte Montagesituation ausgebildet ist. Das Gehäuse und das Basismodul sind für eine feste aber lösbare Verbindung ausgebildet. Damit ist in Abhängigkeit von der Montagesituation das Gehäuse mit einem an die jeweilige Montagesituation angepassten Basismodul verbindbar. Das Basismodul ist als Installationskasten mit einer Sammelschiene ausgeführt, wodurch eine geringe Bauhöhe erzielt werden kann.

In WO 90/ 07 814 A1 ist ein elektrischer Steckverbinder in einem Netzwerk beschrieben, welcher eine Buchse und einen Stecker aufweist.

In Euchner GmbH :" Betriebsanleitung Sicherheitssysteme", 3. Januar 2015 sind Sicherheitszuhaltesysteme beschrieben, die jeweils ein Zuhaltemodul aufweisen.

Der Erfindung liegt die Aufgabe zugrunde, eine Modulanordnung der eingangs genannten Art bereitzustellen, welche bei einem konstruktiv einfachen Aufbau eine hohe Funktionalität aufweist.

Zur Lösung dieser Aufgabe sind die Merkmale des Anspruchs 1 vorgesehen. Vorteilhafte Ausführungsformen und zweckmäßige Weiterbildungen der Erfindung sind in den abhängigen Ansprüchen beschrieben.

Die Erfindung betrifft Modularanordnung mit wenigstens einem Grundmodul, an welches an zwei verschiedenen Seiten jeweils ein Anschlussmodul aufweist, und mit wenigstens einem Funktionsmodul mit wenigstens einem Anschlussmodul. Die Modularanordnung bildet ein Sicherheitssystem aus. Die Anschlussmodule des Grundmoduls sind hinsichtlich ihrer mechanischen und elektrischen Anschlüsse drehsymmetrisch bezüglich einer Drehung um 180° des Grundmoduls ausgebildet, so dass durch Drehen des Grundmoduls wahlweise dessen erstes oder zweites Anschlussmodul am Anschlussmodul des Funktionsmoduls kontaktiert werden kann. Dies bildet ein Sicherheitszuhaltesystem aus, wobei das Grundmodul als Zuhaltemodul ausgebildet ist, und dass das Zuhaltemodul eine Aufnahme für ein Griffmodul aufweist. Durch die drehinvariante Ausbildung des Anschlussmoduls wird das Zuhaltemodul in einer ersten Drehstellung das erste Anschlussmodul des Zuhaltemoduls an einem Anschlussmodul eines Funktionsmoduls angeschlossen, wobei ein Griffmodul rechtsseitig an der Aufnahme befestigt ist. In einer zweiten Drehstellung wird das zweite Anschlussmodul des Zuhaltemoduls an dem Anschlussmodul des Funktionsmoduls angeschlossen und ein Griffmodul linksseitig an der Aufnahme befestigt.

Durch die drehinvariante Ausbildung der Anschlussmodule des Grundmoduls kann dieses in zwei unterschiedlichen Drehpositionen an das zugeordnete Funktionsmodul angeschlossen werden. Damit können mit ein und demselben Grundmodul zwei unterschiedliche Anordnungen von Funktionsmodulen und Grundmodulen realisiert werden und somit unterschiedliche Applikationen realisiert werden, ohne dass hierfür unterschiedliche Varianten von Grundmodulen vorgesehen sein müssen. Damit wird eine hohe Flexibilität und Funktionalität der erfindungsgemäßen Modulanordnung erhalten.

Erfindungsgemäß sind die Anschlussmodule des Grundmoduls drehsymmetrisch bezüglich einer Drehung um 180° des Grundmoduls ausgebildet.

Die Drehinvarianz der Anschlussmodule des Grundmoduls wird vorteilhaft dadurch erreicht, dass einander entsprechende Anschlüsse der beiden Anschlussmodule im Grundmodul miteinander über elektrische Leitungen verbunden sind.

Ein weiterer wesentlicher Aspekt der erfindungsgemäßen Modulanordnung besteht darin, dass die Anschlussmodule ein modulares System bilden, wobei Anschlussmodule austauschbar an dem oder den Grundmodulen und/oder Funktionsmodulen montierbar sind.

Damit können mit geringem Aufwand unterschiedliche Anschlusskonfigurationen für die Modulanordnung realisiert werden.

Ein weiterer Vorteil besteht darin, dass bei Defekten einzelner Module nicht die gesamte Modulanordnung getauscht werden muss, sondern nur einzelne Module getauscht werden müssen, was den Aufwand für anfallende Reparaturen erheblich reduziert.

Gemäß einer besonders vorteilhaften Ausgestaltung der Erfindung kommunizieren die über Anschlussmodule verbundenen Grundmodule und/oder Funktionsmodule über ein Datenbussystem.

Das Datenbussystem ist dabei derart ausgebildet, dass in dem oder jedem Grundmodul oder Funktionsmodul Leiterplatten vorgesehen sind, in welchem Busleitungen des Datenbussystems verlaufen.

Hierzu angepasst weisen die Anschlussmodule Kontaktschnittstellen zum Anschluss an die Leiterplatten der Grundmodule und/oder Funktionsmodule auf.

Vorteilhaft sind die Kontaktschnittstellen in Form von Federkontakten ausgebildet.

Mit dem Datenbussystem als internem Bussystem der Modulanordnung erfolgt eine Kommunikation der einzelnen Module der Modulanordnung. Das Datenbussystem arbeitet dabei völlig unabhängig von externen Bussystemen, an welche die Modulanordnung gegebenenfalls angeschlossen wird. Durch die konstruktive Ausgestaltung des Datenbussystems derart, dass die Busleitungen in Leiterplatten der Module geführt sind, kann auf aufwändige Verkabelungen innerhalb der Module verzichtet werden. Dieser Vorteil wird dadurch noch verstärkt, dass die Kontaktschnittstellen der Anschlussmodule direkt auf den Leiterplatten kontaktiert werden können. Besonders vorteilhaft sind die Kontaktschnittstellen von Funktionsmodulen gebildet, die einfach durch Anpressen gegen Kontaktstellen an den Leiterplatten elektrisch kontaktiert werden können. Da alle Module an die Kontaktschnittstellen der Anschlussmodule angepasste Schnittstellen aufweisen, wird dadurch die Modularität der gesamten Modulanordnung noch weiter gesteigert, da beliebige Module miteinander kombinierbar sind, ohne dass hierfür in den Modulen konstruktive Änderungen wie beispielsweise eine geänderte Verlegung von Kabeln vorgenommen werden muss.

Bei der erfindungsgemäßen Modulanordnung sind die Anschlussmodule in Form von Steckern oder Buchsen ausgebildet.

Dabei sind ein Stecker und eine Buchse direkt oder über ein Kabel miteinander verbunden.

Bei einer direkten Verbindung eines Steckers eines Moduls und einer Buchse eines anderen Moduls sind die Module direkt aneinander angrenzend miteinander verbunden. Ist dagegen noch ein Kabel zwischen Stecker und Buchse vorgesehen, können die Module räumlich abgesetzt voneinander platziert werden.

Die Stecker und Buchsen können dabei in unterschiedlichen konstruktiven Ausprägungen ausgebildet sein, wodurch die Variantenvielfalt der Modulanordnung weiter erhöht wird.

Gemäß einer vorteilhaften Ausgestaltung weist jeder Stecker ein genormtes Anschlusselement mit einem Außengewinde auf. Jede Buchse weist einen Grundkörper mit einer Kontaktschnittstelle auf, wobei dem Grundkörper ein erster Aufsatz mit einer Bohrung mit einem Innengewinde, in welches Kabelstecker und dergleichen eingeschraubt werden können, und ein zweiter Aufsatz mit einer Bohrung ohne Innengewinde, welche ausgebildet ist, das Anschlusselement des Steckers aufzunehmen, zugeordnet sind.

Durch ein wahlweises Fixieren eines der Aufsätze am Grundkörper können mit geringem Aufwand zwei unterschiedliche Anschlussmöglichkeiten realisiert werden. Besonders vorteilhaft hierbei ist, dass ein und derselbe Grundkörper der Buchse für beide Aufsätze verwendet werden kann.

Die einzelnen Module der erfindungsgemäßen Modulanordnung, das heißt die Grundmodule und Funktionsmodule können allgemein von Elektronikmodulen gebildet sein, die unterschiedliche Funktionen erfüllen können, so dass die dadurch gebildete Modulanordnung in industriellen Anwendungen aller Art eingesetzt werden kann.

Erfindungsgemäß bildet die Modulanordnung ein Sicherheitssystem, in Form eines Sicherheitszuhaltesystems aus.

Das Sicherheitszuhaltesystem weist wenigstens ein Grundmodul in Form eines Zuhaltemoduls auf. Weiterhin weist das Sicherheitszuhaltesystem ein Funktionsmodul in Form eines Bedienmoduls und/oder ein Funktionsmodul in Form eines Busmoduls auf.

Dabei weist das Zuhaltemodul eine Aufnahme für ein Griffmodul auf, wobei durch die drehinvariante Ausbildung das Anschlussmodul des Zuhaltemoduls in einer ersten Drehstellung einem Anschlussmodul des Zuhaltemoduls an einem Anschlussmodul eines Funktionsmoduls angeschlossen und ein Griffmodul rechtsseitig an der Aufnahme befestigt ist. In einer zweiten Drehstellung ist das zweite Anschlussmodul des Zuhaltemoduls an dem Anschlussmodul des Funktionsmoduls angeschlossen und ein Griffmodul linksseitig an der Aufnahme befestigt.

Durch die drehinvariante Ausbildung des Zuhaltemoduls kann dieses somit in unveränderter Weise für ein rechtsseitig als auch linksseitig anschließendes Griffmodul verwendet werden, wodurch die Anzahl der Komponenten des Sicherheitszuhaltesystems zur Realisierung dieser Varianten äußerst gering gehalten werden kann.

Die Erfindung wird im Folgenden anhand der Zeichnungen erläutert. Es zeigen:
- Figur 1:: Erste Variante eines Ausführungsbeispiels der erfindungsgemäßen Modulanordnung.
- Figur 2:: Zweite Variante der Modulanordnung gemäß Figur 1.
- Figur 3:: Dritte Variante der Modulanordnung gemäß Figur 1.
- Figur 4:: Schematische Darstellung der elektrischen Anschlüsse der einzelnen Anschlussmodule der Modulanordnung gemäß Figur 1.
- Figur 5:: Schematische Darstellung der elektrischen Anschlüsse der einzelnen Anschlussmodule der Modulanordnung gemäß Figur 2.
- Figur 6:: Ausführungsform eines Steckers als Anschlussmodul für die Modulanordnung der Figuren 1 bis 3.
- Figur 7:: Erste Variante einer Buchse als Anschlussmodul für die Modulanordnung der Figuren 1 bis 3.
- Figur 8:: Zweite Variante einer Buchse als Anschlussmodul für die Modulanordnung der Figuren 1 bis 3.

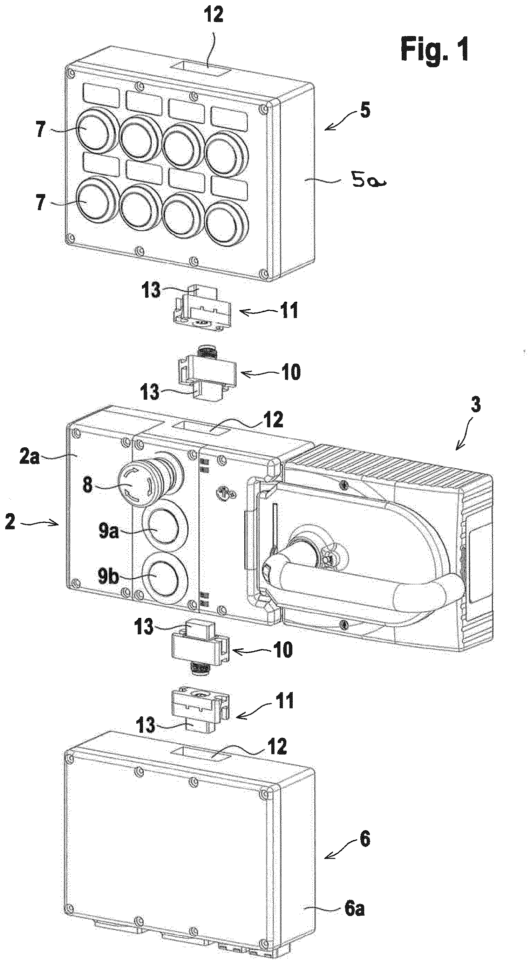

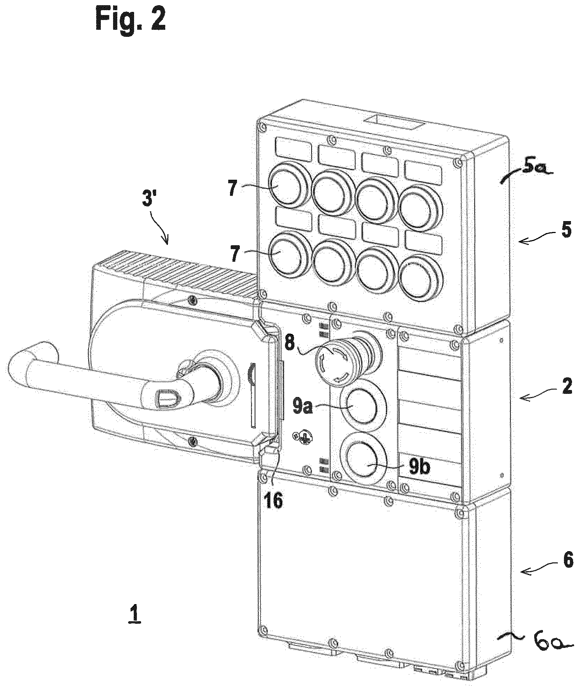

Die Figuren 1 bis 3 zeigen drei Varianten eines Ausführungsbeispiels der erfindungsgemäßen Modulanordnung 1. Die Modulanordnung 1 bildet im vorliegenden Fall ein Sicherheitssystem, spezifisch ein Sicherheitszuhaltesystem, welches als Grundmodul ein Zuhaltemodul 2 aufweist. Bei der Anordnung der Figur 1 ist am Zuhaltemodul 2 an seiner rechten Seite ein rechtsseitiges Griffmodul 3 angeordnet. Bei der Anordnung der Figur 2 ist an demselben Zuhaltemodul 2 an seiner linken Seite ein linksseitiges Griffmodul 3' angeordnet. In beiden Fällen weist das Griffmodul 3, 3' einen Türdrücker 4 auf.

Das Zuhaltemodul 2 und das Griffmodul 3, 3' bilden eine Funktionseinheit, die ein sicheres Zuhalten einer Schutztür oder dergleichen gewährleistet. Der Türdrücker 4 kann prinzipiell mit einer Federkraft in zugehaltener Stellung gehalten werden und durch Magnetkraft entsperrt werden. Im vorliegenden Fall wird der Türdrücker 4 mittels einer Magnetkraft, die mittels eines im Zuhaltemodul 2 angeordneten Magneten erzeugt wird, in zugehaltener Stellung gehalten und durch eine Federkraft entsperrt.

Die Modulanordnung 1 der Figuren 1 bis 3 weist weiterhin als erstes Funktionsmodul ein Bedienmodul 5 und als zweites Funktionsmodul ein Busmodul 6 auf. Das Bedienmodul 5 bildet eine Bedieneinheit und weist als Bedienelemente mehrere Tasten 7 auf. Das Zuhaltemodul 2 selbst weist einen Nothalt-Taster 8 und weitere Tasten 9a, 9b für eine Bedienung des Sicherheitssystems auf. Das Busmodul 6 dient zum Anschluss des Sicherheitssystems an ein externes Bussystem.

Die Modulanordnung 1 der Figuren 1 bis 3 kann generell auch dahin erweitert sein, dass diese mehrere Zuhaltemodule 2 mit Griffmodulen 3, 3' oder auch mehrere Funktionsmodule wie Busmodule 6 oder Bedienmodule 5 aufweist.

Die elektrische Verbindung zwischen dem Grundmodul und dem Funktionsmodul wird durch Anschlussmodule bewerkstelligt, die in Form von Steckern 10 oder Buchsen 11 gebildet sind.

Ein derartiges Anschlussmodul wird zur Montage an dem Grundmodul oder einem Funktionsmodul in eine Aussparung 12 in dessen Gehäuse 2a, 5a, 6a eingesetzt. Bei Einsetzen des Anschlussmoduls wird dieses an einer nicht dargestellten Leiterplatte im Grundmodul oder im Funktionsmodul elektrisch kontaktiert. In der Leiterplatte verlaufen Busleitungen eines Datenbussystems, das ein internes Bussystem des Sicherheitssystems bildet, welches unabhängig von externen Bussystemen arbeitet. Das Datenbussystem kann insbesondere als CAN-Bus ausgebildet sein. Zur Kontaktierung an den Leiterplatten weist jedes Anschlussmodul eine Kontaktschnittstelle 13 auf.

Die Anschlussmodule bilden ein modulares System, welche wahlweise mit dem Grundmodul und dem Funktionsmodul kombiniert werden können. Dabei kann ein Stecker 10 und eine Buchse 11 dazu genutzt werden, das Zuhaltemodul 2 direkt mit einem Funktionsmodul zu verbinden, wie in den Figuren 1 und 2 dargestellt. Alternativ kann zwischen einem Stecker 10 und einer Buchse 11 ein Kabel 14 vorgesehen sein, so dass das Zuhaltemodul 2 und die Funktionsmodule in Abstand zueinander positionierbar sind.

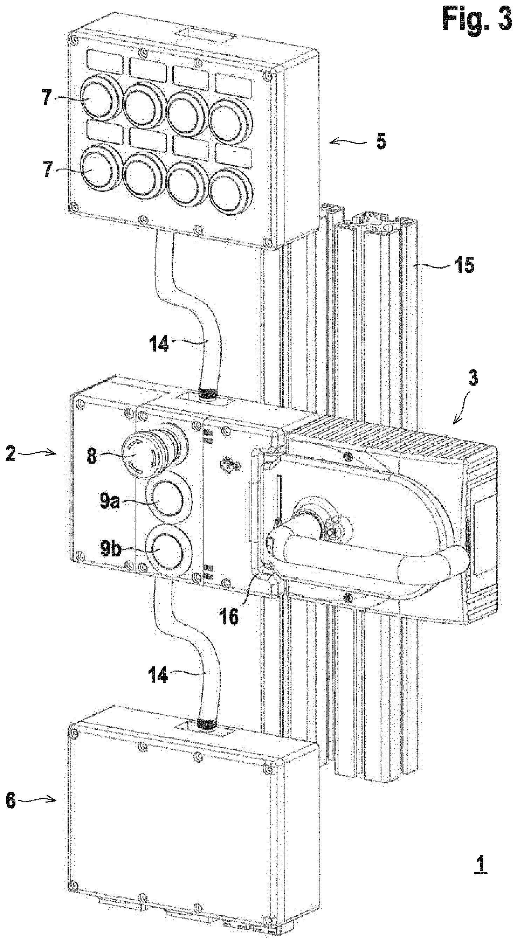

Vorteilhaft werden die Module des Sicherheitssystems an einer Profilschiene 15 befestigt, die in Figur 3 dargestellt ist.

Erfindungsgemäß weist das Zuhaltemodul 2 als Grundmodul der Modulanordnung 1 an gegenüberliegenden Seiten zwei Anschlussmodule auf, die hinsichtlich ihrer elektrischen Anschlüsse drehinvariant bezüglich einer Drehung des Zuhaltemoduls 2 um 180° sind. Dies bedeutet, dass das Zuhaltemodul 2 sowohl in einer ersten Drehstellung (dargestellt in Figur 1) als auch in einer um 180° diesbezüglich gedrehten zweiten Drehstellung (dargestellt in Figur 2) völlig identische Anschlussschnittstellen zum Bedienmodul 5 und zum Busmodul 6 ausbildet und damit ohne zusätzliche Busschaltungen in beiden Drehstellungen in identischer Weise an das Bedienmodul 5 und das Busmodul 6 angeschlossen werden kann. Dies wiederum bedeutet, dass ein und dasselbe Zuhaltemodul 2 sowohl zum Anschluss des rechtsseitigen Griffmodul 3 (Figur 1) als auch zum Anschluss des linksseitigen Griffmoduls 3' (Figur 2) verwendet werden kann. Im ersten Fall (Figur 1) mündet eine Aufnahme 16 des Zuhaltemoduls 2 rechts aus, um das rechtsseitige Griffmodul 3 aufzunehmen. Im zweiten Fall (Figur 2) mündet die Aufnahme 16 links aus, um das linksseitige Griffmodul 3' aufzunehmen.

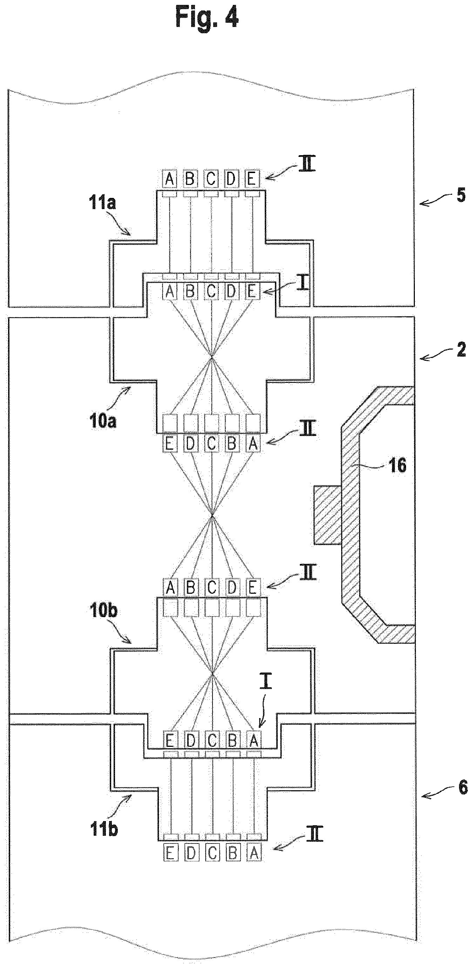

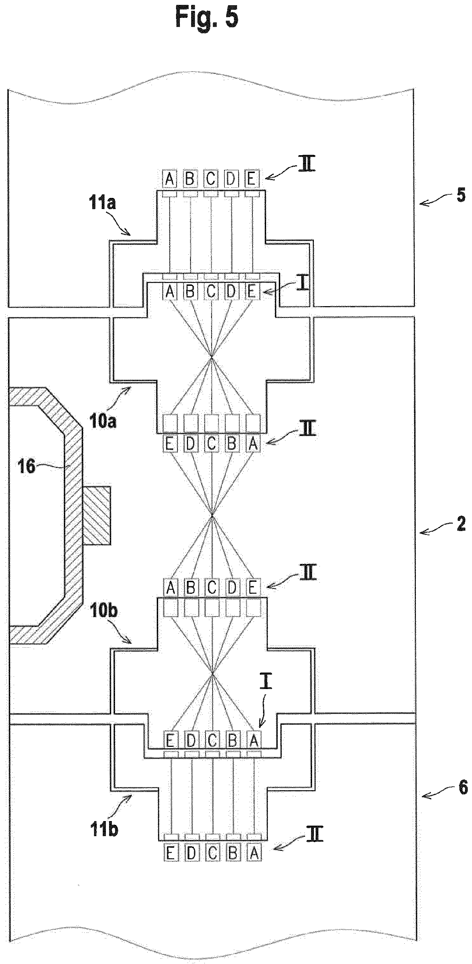

Die Drehinvarianz der elektrischen Anschlüsse der Anschlussmodule des Zuhaltemoduls 2 wird durch die in den Figuren 4 und 5 dargestellten Anschlussanordnungen erhalten.

Die Figuren 4 und 5 zeigen schematisch das Zuhaltemodul 2 mit zwei Steckern 10a, 10b als Anschlussmodul und das Bedienmodul 5 und das Busmodul 6 mit jeweils einer Buchse 11a, 11b als Anschlussmodule. Alternativ könnte auch das Zuhaltemodul 2 mit zwei Buchsen 11a, 11b ausgestattet sein. Dann wären im Bedienmodul 5 und im Busmodul 6 korrespondierend hierzu Stecker 10 vorgesehen.

Jede Buchse 11a, 11b und jeder Stecker 10a, 10b der Anordnung der Figuren 4 und 5 weist außenliegende Anschlusskontakte A, B, C, D, E auf (jeweils mit I bezeichnet), die dem jeweiligen Anschlusskontakt A, B, C, D, E des gegenüberliegenden, zugeordneten Anschlussmoduls zugeordnet sind. Weiterhin weist jede Buchse 11a, 11b und jeder Stecker 10a, 10b der Anordnung der Figuren 4 und 5 innenliegende Anschlusskontakte A, B, C, D, E auf (jeweils mit II bezeichnet), die jeweils an die innenliegende Leiterplatte des Zuhaltemoduls 2, Bedienmoduls 5 beziehungsweise Busmoduls 6 angeschlossen sind.

Bei den im Bedienmodul 5 beziehungsweise Busmodul 6 integrierten Buchsen 11a, 11b sind die innenliegenden Anschlusskontakte II und die außenliegenden Anschlusskontakte I jeweils über geradlinig verlaufende Zuleitungen verbunden, so dass die Anordnung A, B, C, D, E der innenliegenden Anschlusskontakte II der Anordnung A, B, C, D, E der außenliegenden Anschlusskontakte I entspricht.

Bei den Steckern 10a, 10b im Zuhaltemodul 2 sind jedoch die innenliegenden Anschlusskontakte II mit den außenliegenden Anschlusskontakten I über gekreuzte Zuleitungen verbunden, so dass die Reihenfolge der innenliegenden Anschlusskontakte II (A, B, C, D, E) zu der Reihenfolge der außenliegenden Anschlusskontakte I (E, D, C, B, A) umgekehrt ist. Weiterhin sind die innenliegenden Anschlusskontakte II der Stecker 10a, 10b über gekreuzte Zuleitungen verbunden, wobei die Reihenfolge der Anschlusskontakte II des Steckers 10b (A, B, C, D, E) bezüglich der Reihenfolge der Anschlusskontakte I des Steckers 10a (E, D, C, B, A) umgekehrt ist.

Durch diese Verdrahtung der Anschlusskontakte I, II der Stecker 10a, 10b sind deren Anschlüsse drehinvariant bezüglich einer Drehung um 180°, wie der Vergleich der Figuren 4 und 5 zeigt. Bei der Anordnung gemäß Figur 4 befindet sich das Zuhaltemodul 2 in einer ersten Drehposition, in der die Aufnahme 16 für den Anschluss eines rechtsseitigen Griffmoduls 3 rechts liegt. Bei der Anordnung gemäß Figur 5 befindet sich das Zuhaltemodul 2 in einer um 180° zur ersten Drehposition gedrehten zweiten Drehposition, in der die Aufnahme 16 für den Anschluss eines linksseitigen Griffmoduls 3' links liegt. Bei beiden Anordnungen sind völlig identische Anschlüsse der Stecker 10a, 10b zu den Buchsen 11a, 11b des Bedienmoduls 5 beziehungsweise Busmoduls 6 gegeben.

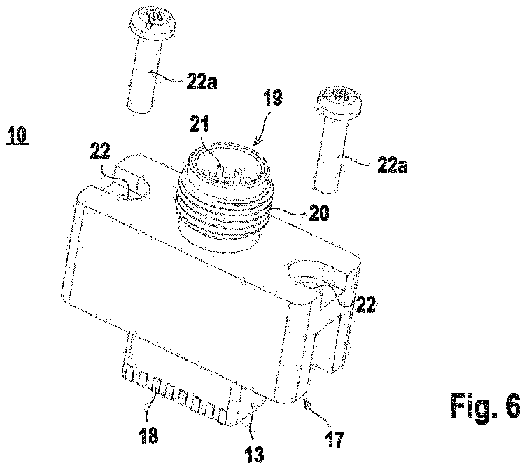

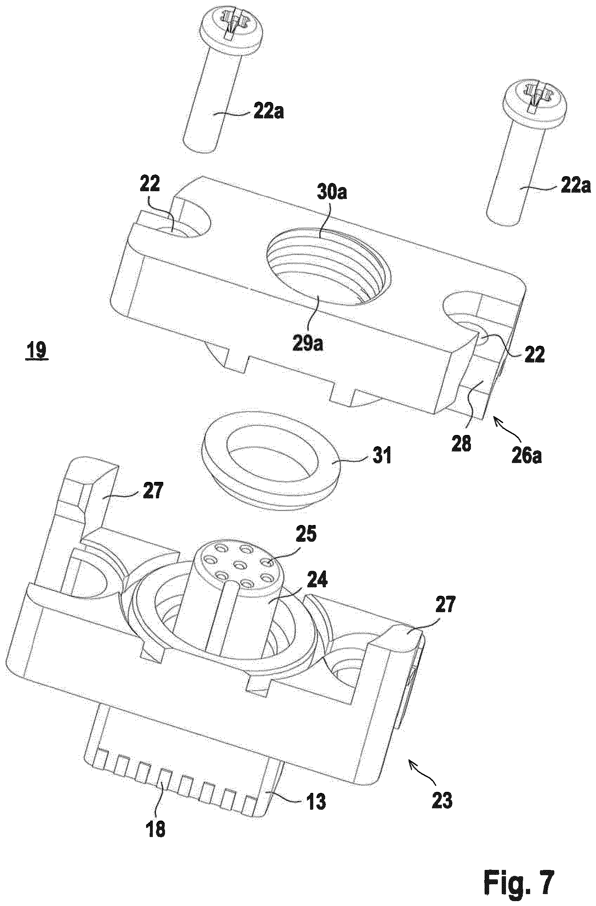

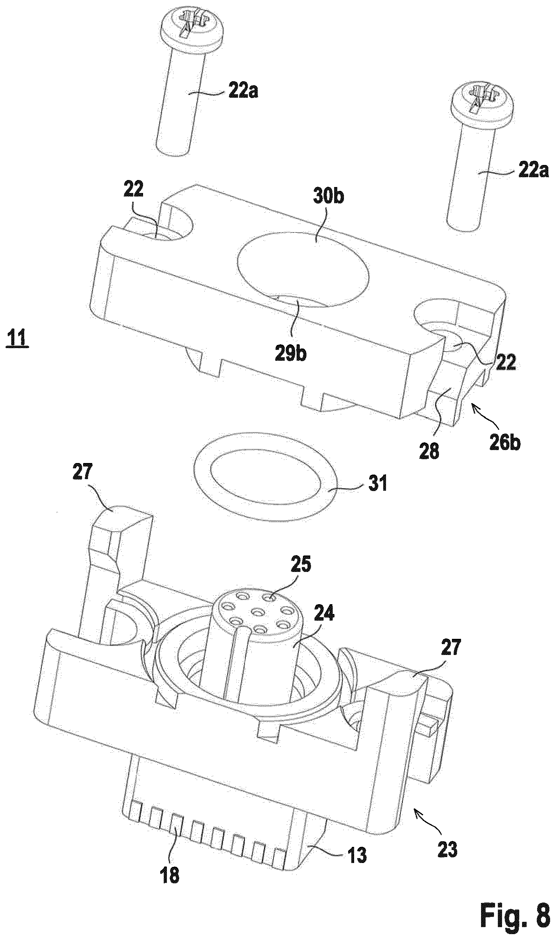

Die Figuren 6 bis 8 zeigen in Detaildarstellungen die Ausbildung der Anschlussmodule für die Modulanordnung 1 der Figuren 1 bis 3. Figur 6 zeigt eine Ausführungsform eines Steckers 10. Der Stecker 10 weist einen Stecker-Grundkörper 17 auf, an dessen Unterseite die Kontaktschnittstelle 13 ausmündet. Die Kontaktschnittstelle 13 weist Federkontakte 18 auf, mittels derer eine Kontaktierung an Kontaktpads der Leiterplatte im Zuhaltemodul 2 erfolgen kann. An der Oberseite mündet ein Anschlusselement 19 aus, das im vorliegenden Fall eine genormte M12-Schnittstelle ausbildet. Das Anschlusselement 19 ist hohlzylindrisch ausgebildet und weist an seiner Außenseite ein Außengewinde 20, im vorliegenden Fall ein M12-Gewinde auf. Im Inneren des Anschlusselements 19 verlaufen mehrere Kontaktstifte 21. Der Stecker-Grundkörper 17 weist seitlich zwei Befestigungsbohrungen 22 auf, durch welche Schrauben 22a geführt werden können, um so den Stecker 10 am Zuhaltemodul 2 zu fixieren. Dem Stecker 10 gemäß Figur 6 sind zwei Varianten einer Buchse 11 zugeordnet, welche in den Figuren 7 und 8 dargestellt sind. Die Buchse 11 weist einen für beide Varianten identischen Grundkörper 23 auf, an dessen Unterseite, entsprechend der Ausbildung des Steckers 10, die Kontaktschnittstelle 13 mit den Federkontakten 18 vorgesehen ist. An der Oberseite des Grundkörpers 23 befindet sich ein zylindrisches Anschlussteil 24 mit Kontaktelementen 25 in Form von Kontaktbohrungen, in welche die Kontaktstifte 21 des Steckers 10 eingesteckt werden.

Zur Ausbildung zweier unterschiedlicher Buchsen-Varianten sind dem Grundkörper 23 zwei verschiedene Aufsätze 26a, 26b zugeordnet, die in den Figuren 7 und 8 dargestellt sind. Beide Aufsätze 26a, 26b weisen dieselbe Außenkontur auf, so dass wahlweise einer der Aufsätze 26a, 26b auf den Grundkörper 23 aufgesetzt werden kann. Zur Lagefixierung dieser Teile weist der Grundkörper 23 Vorsprünge 27 auf, die auf komplementär hierzu ausgebildete Ausnehmungen 28 in den Aufsätzen 26a, 26b aufgesetzt werden können. Weiterhin weisen die Aufsätze 26a, 26b analog zum Stecker 10 seitlich zwei Befestigungsbohrungen 22 auf, in welche die Schrauben 22a eingeführt werden können, um die Buchse 11 am Bedienmodul 5 oder Busmodul 6 fixieren zu können.

Die Aufsätze 26a, 26b unterscheiden sich hinsichtlich der Ausbildung zentraler Bohrungen 29a, 29b, die bei auf dem Grundkörper 23 aufgesetzten Aufsatz 26a, 26b das Anschlussteil 24 des Grundkörpers 23 mit Spiel umschließen. Die Bohrung 29a des Aufsatzes 26a wird durch ein Innengewinde 30a begrenzt, während die Bohrung 29b des Aufsatzes 26b durch ein glattes Wandelement 30b des Aufsatzes 26b begrenzt ist.

Der entsprechende Aufsatz 26a, 26b wird mit einer Dichtung 31 in Form eines O-Rings auf den Grundkörper 23 zur Ausbildung der Buchse 11 aufgesetzt.

Entsprechend der unterschiedlich ausgebildeten Bohrungen 29a, 29b werden Buchsen 11 mit unterschiedlicher Funktionalität erhalten. In die Buchse 11 mit dem Aufsatz 26a gemäß Figur 7 können Kabelstecker und dergleichen eingeschraubt werden. Demgegenüber wird die Buchse 11 mit dem Aufsatz 26b gemäß Figur 8 auf den Stecker 10 gemäß Figur 6 aufgesteckt, wobei dann das die Bohrung 29b umschließende Wandelement 30b das Anschlusselement 19 des Steckers 10 mit geringem Spiel umschließt.

### Bezugszeichenliste

- (1): Modulanordnung
- (2): Zuhaltemodul
- (2a): Gehäuse
- (3): Griffmodul rechtsseitig
- (3'): Griffmodul linksseitig
- (4): Türdrücker
- (5): Bedienmodul
- (5a): Gehäuse
- (6): Busmodul
- (6a): Gehäuse
- (7): Tasten
- (8): Nothalt-Taster
- (9 a, b): Tasten
- (10 a, b): Stecker
- (11 a, b): Buchse
- (12): Aussparung
- (13): Kontaktschnittstelle
- (14): Kabel
- (15): Profilschiene
- (16): Aufnahme
- (17): Stecker-Grundkörper
- (18): Federkontakt
- (19): Anschlusselement
- (20): Außengewinde
- (21): Kontaktstift
- (22): Befestigungsbohrung
- (22a): Schrauben
- (23): Grundkörper
- (24): Anschlussteil
- (25): Kontaktelement
- (26 a, b): Aufsatz
- (27): Vorsprung
- (28): Ausnehmung
- (29 a, b): Bohrung
- (30a): Innengewinde
- (30b): Wandelement
- (31): Dichtung

- (I): Anschlusskontakt A, B, C, D, E
- (II): Anschlusskontakt A, B, C, D, E

## Patentansprüche

1. Modulanordnung (1) mit wenigstens einem Grundmodul, welches an zwei verschiedenen Seiten jeweils ein Anschlussmodul aufweist, und mit wenigstens einem Funktionsmodul mit wenigstens einem Anschlussmodul, wobei die Modulanordnung (1) ein Sicherheitssystem ausbildet, und wobei die Anschlussmodule des Grundmoduls hinsichtlich ihrer mechanischen und elektrischen Anschlüsse drehsymmetrisch bezüglich einer Drehung um 180° des Grundmoduls ausgebildet sind, so dass durch Drehen des Grundmoduls wahlweise dessen erstes oder zweites Anschlussmodul am Anschlussmodul des Funktionsmoduls kontaktiert werden kann, **dadurch gekennzeichnet, dass** diese ein Sicherheitszuhaltesystem ausbildet, wobei das Grundmodul als Zuhaltemodul (2) ausgebildet ist, und dass das Zuhaltemodul (2) eine Aufnahme (16) für ein Griffmodul (3, 3') aufweist, wobei durch die drehinvariante Ausbildung des Anschlussmoduls das Zuhaltemodul (2) in einer ersten Drehstellung das erste Anschlussmodul des Zuhaltemoduls (2) an einem Anschlussmodul eines Funktionsmoduls angeschlossen und ein Griffmodul (3) rechtsseitig an der Aufnahme (16) befestigt ist und in einer zweiten Drehstellung das zweite Anschlussmodul des Zuhaltemoduls (2) an dem Anschlussmodul des Funktionsmoduls angeschlossen und ein Griffmodul (3') linksseitig an der Aufnahme (16) befestigt ist.

2. Modulanordnung nach Anspruch 1, **dadurch gekennzeichnet, dass** einander entsprechende Anschlüsse der beiden Anschlussmodule im Grundmodul miteinander über elektrische Leitungen verbunden sind.

3. Modulanordnung nach einem der Ansprüche 1 oder 2, **dadurch gekennzeichnet, dass** die Anschlussmodule ein modulares System bilden, wobei Anschlussmodule austauschbar an dem oder den Grundmodulen und/oder Funktionsmodulen montierbar sind.

4. Modulanordnung nach einem der Ansprüche 1 bis 3, **dadurch gekennzeichnet, dass** die über Anschlussmodule verbundenen Grundmodule und/oder Funktionsmodule über ein Datenbussystem kommunizieren.

5. Modulanordnung nach Anspruch 4, **dadurch gekennzeichnet, dass** in dem oder jedem Grundmodul oder Funktionsmodul Leiterplatten vorgesehen sind, in welchem Busleitungen des Datenbussystems verlaufen.

6. Modulanordnung nach Anspruch 5, **dadurch gekennzeichnet, dass** die Anschlussmodule Kontaktschnittstellen (13) zum Anschluss an die Leiterplatten der Grundmodule und/oder Funktionsmodule aufweisen.

7. Modulanordnung nach Anspruch 6, **dadurch gekennzeichnet, dass** die Kontaktschnittstellen (13) in Form von Federkontakten (18) ausgebildet sind.

8. Modulanordnung nach einem der Ansprüche 1 bis 7, **dadurch gekennzeichnet, dass** die Anschlussmodule in Form von Steckern (10, 10a, 10b) oder Buchsen (11, 11a, 11b) ausgebildet sind.

9. Modulanordnung nach Anspruch 8, **dadurch gekennzeichnet, dass** ein Stecker (10a, 10b) und eine Buchse (11a, 11b) direkt oder über ein Kabel (14) miteinander verbunden sind.

10. Modulanordnung nach einem der Ansprüche 8 oder 9, **dadurch gekennzeichnet, dass** jeder Stecker (10a, 10b) ein genormtes Anschlusselement (19) mit einem Außengewinde (20) aufweist.

11. Modulanordnung nach Anspruch 10, **dadurch gekennzeichnet, dass** jede Buchse (11, 11a, 11b) einen Grundkörper (23) mit einer Kontaktschnittstelle (13) aufweist, wobei dem Grundkörper (23) ein erster Aufsatz (26a) mit einer Bohrung (29a) mit einem Innengewinde (30a) und ein zweiter Aufsatz (26b) mit einer Bohrung (29b) ohne Innengewinde (30a) zugeordnet sind.

12. Modulanordnung nach Anspruch 11, **dadurch gekennzeichnet, dass** wahlweise ein Aufsatz (26a, 26b) am Grundkörper (23) der Buchse (11, 11a, 11b) fixierbar ist.

13. Modulanordnung nach einem der Ansprüche 1 - 12, **dadurch gekennzeichnet, dass** das Sicherheitszuhaltesystem ein Funktionsmodul in Form eines Bedienmoduls (5) und/oder ein Funktionsmodul in Form eines Busmoduls (6) aufweist.

## Claims

1. Module assembly (1) with at least one base module, which comprises a respective connecting module at each of two different sides, and with at least one function module with at least one connecting module, wherein the module assembly (1) forms a safety system and wherein the connecting modules of the base module are constructed with respect to the mechanical and electrical connections thereof to be rotationally symmetrical with respect a rotation through 180° of the base module so that through rotation of the base module selectably the first or second connecting module thereof can be brought into contact with the connecting module of the function module, **characterised in that** this forms a safety retaining system, wherein the base module is constructed as a retaining module (2), and that the retaining module (2) has a receptacle (16) for a grip module (3, 3'), wherein through the rotationally invariant construction of the connecting module the retaining module (2) in a first rotational setting is connected at the first connecting module of the retaining module (2) with a connecting module of a function module and a grip module (3) is secured to the receptacle (16) on the righthand side and in a second rotational setting the second connecting module of the retaining module (2) is connected with the connecting module of the function module and a grip module (3') is secured to the receptacle (16) on the lefthand side.

2. Module assembly according to claim 1, **characterised in that** mutually corresponding connections of the two connecting modules are connected together in the base module by way of electrical lines.

3. Module assembly according to one of claims 1 and 2, **characterised in that** the connecting modules form a modular system, wherein connecting modules can be exchangably mounted at the base module or modules and/or the function module or modules.

4. Module assembly according to any one of claims 1 to 3, **characterised in that** the base modules and/or function modules connected by way of connecting modules communicate by way of a data bus system.

5. Module assembly according to claim 4, **characterised in that** circuitboards in which bus conductors of the data bus system run are provided run in the or each base module or function module.

6. Module assembly according to claim 5, **characterised in that** the connecting modules have contact interfaces (13) for connection with the circuitboards of the base modules and/or function modules.

7. Module assembly according to claim 6, **characterised in that** the contact interfaces (13) are constructed in the form of spring contacts (18).

8. Module assembly according to any one of claims 1 to 7, **characterised in that** the connecting modules are constructed in the form of plugs (10, 10a, 10b) or bushes (11, 11a, 11b).

9. Module assembly according to claim 8, **characterised in that** a plug (10a, 10b) and a bush (11a, 11b) are connected together directly or by way of a cable (14).

10. Module assembly according to one of claims 8 and 9, **characterised in that** each plug (10a, 10b) has a standardised connection element (19) with an external thread (20).

11. Module assembly according to claim 10, **characterised in that** each bush (11, 11a, 11b) comprises a base body (23) with a contact interface (13), wherein a first attachment (26a) with a bore (29a) with an internal thread (30a) is associated with the base body (23) and a second attachment (26b) with a bore (29b) without an internal thread (30a) is associated with the base body (23).

12. Module assembly according to claim 11, **characterised in that** a selectable attachment (26a, 26b) is fixable to the base body (23) of the bush (11, 11a, 11b).

13. Module assembly according to any one of claims 1 to 12, **characterised in that** the safety retaining system comprises a function module in the form of a control module (5) and/or a function module in the form of a bus module (6).

## Revendications

1. Agencement (1) de modules, comprenant au moins un module de base muni d'un module respectif de raccordement sur deux côtés différents, et au moins un module fonctionnel doté d'au moins un module de raccordement, sachant que ledit agencement (1) de modules constitue un système de sécurité, et sachant que les modules de raccordement dudit module de base présentent, concernant leurs liaisons mécaniques et électriques, une réalisation à symétrie rotatoire par rapport à une rotation de 180° dudit module de base, de sorte qu'une rotation dudit module de base permet, sélectivement, une mise en contact de son premier ou de son second module de raccordement avec le module de raccordement dudit module fonctionnel, **caractérisé par le fait que** ledit agencement constitue un système de verrouillage de sécurité, le module de base étant conçu en tant que module de verrouillage (2) ; et **par le fait que** le module de verrouillage (2) est pourvu d'un logement (16) destiné à un module de poignée (3, 3'), sachant que, du fait de la réalisation à invariance rotationnelle des modules de raccordement dudit module de verrouillage (2), le premier module de raccordement dudit module de verrouillage (2) est connecté à un module de raccordement d'un module fonctionnel et un module de poignée (3) est fixé au logement (16) du côté droit, dans une première position prise par rotation et, dans une seconde position prise par rotation, le second module de raccordement dudit module de verrouillage (2) est connecté audit module de raccordement du module fonctionnel, et un module de poignée (3') est fixé audit logement (16) du côté gauche.

2. Agencement de modules selon la revendication 1, **caractérisé par le fait que** des connexions mutuellement correspondantes des deux modules de raccordement sont reliées mutuellement, dans le module de base, par l'intermédiaire de conducteurs électriques.

3. Agencement de modules selon l'une des revendications 1 ou 2, **caractérisé par le fait que** les modules de raccordement forment un système modulaire, des modules de raccordement pouvant être montés, de manière interchangeable, sur le ou les module(s) de base et/ou module(s) fonctionnel(s).

4. Agencement de modules selon l'une des revendications 1 à 3, **caractérisé par le fait que** les modules de base et/ou modules fonctionnels, connectés par l'intermédiaire de modules de raccordement, communiquent par l'intermédiaire d'un système à bus de données.

5. Agencement de modules selon la revendication 4, **caractérisé par le fait que** des plaquettes à circuits imprimés, dans lesquelles s'étendent des lignes du système à bus de données, sont prévues dans le, ou dans chaque module de base ou module fonctionnel.

6. Agencement de modules selon la revendication 5, **caractérisé par le fait que** les modules de raccordement sont munis d'interfaces de contact (13) dédiés à la connexion aux plaquettes à circuits imprimés des modules de base et/ou modules fonctionnels.

7. Agencement de modules selon la revendication 6, **caractérisé par le fait que** les interfaces de contact (13) sont réalisés sous la forme de contacts à ressorts (18).

8. Agencement de modules selon l'une des revendications 1 à 7, **caractérisé par le fait que** les modules de raccordement sont réalisés sous la forme de fiches (10, 10a, 10b) ou de douilles (11, 11a, 11b).

9. Agencement de modules selon la revendication 8, **caractérisé par le fait qu'**une fiche (10a, 10b) et une douille (11a, 11b) sont connectées mutuellement en mode direct, ou par l'intermédiaire d'un câble (14).

10. Agencement de modules selon l'une des revendications 8 ou 9, **caractérisé par le fait que** chaque fiche (10a, 10b) comporte un élément de raccordement (19) normalisé, pourvu d'un filetage extérieur (20).

11. Agencement de modules selon la revendication 10, **caractérisé par le fait que** chaque douille (11, 11a, 11b) est dotée d'un corps de base (23) comportant un interface de contact (13), sachant qu'un premier capuchon (26a) muni d'un perçage (29a) pourvu d'un filetage intérieur (30a), et un second capuchon (26b) muni d'un perçage (29b) dépourvu de filetage intérieur (30a), sont affectés audit corps de base (23).

12. Agencement de modules selon la revendication 11, **caractérisé par le fait qu'**un capuchon (26a, 26b) peut être sélectivement bloqué à demeure sur le corps de base (23) de la douille (11, 11a, 11b).

13. Agencement de modules selon l'une des revendications 1 - 12, **caractérisé par le fait que** le système de verrouillage de sécurité présente un module fonctionnel revêtant la forme d'un module d'actionnement (5), et/ou un module fonctionnel revêtant la forme d'un module de bus (6).
